# EUROPÄISCHE PATENTSCHRIFT

(11) **EP 3 240 380 B1**
(45) Veröffentlichungstag und Bekanntmachung des Hinweises auf die Patenterteilung: **21.03.2018**
(21) Anmeldenummer: 16001990.7
(22) Anmeldetag: 13.09.2016
(51) Int. Cl.: H05K 7/14, H05K 1/18, H05K 7/20

(54) **UMRICHTERANORDNUNG**
CONVERTER ASSEMBLY
SYSTÈME DE CONVERTISSEUR

(30) Priorität: 25.04.2016 DE 202016002776 U
(43) Veröffentlichungstag der Anmeldung: 01.11.2017
(73) Patentinhaber: GvA Leistungselektronik GmbH, 68307 Mannheim (DE)
(72) Erfinder: Bresch, Werner, 68239 Mannheim (DE); Rehmann, Erik, 67258 Hessheim (DE); Soldan, Johannes, 68161 Mannheim (DE)
(74) Vertreter: Kesselhut, Wolf

(56) Entgegenhaltungen:
- EP-A2- 2 587 908
- EP-A2- 2 876 985
- DE-B3-102014 101 024
- US-A1- 2012 262 968

## Beschreibung

Die Erfindung betriff eine Umrichteranordnung gemäß dem Oberbegriff von Anspruch 1.

Umrichter und Umrichteranordnungen, insbesondere Wechselrichter oder Gleichrichter, die eine Vielzahl von Leistungshalbleiterschaltem, wie insbesondere IGBTs, sowie eine Vielzahl von Leistungskondensatoren umfassen, werden seit langem von der Anmelderin in kompakter Modulbauweise unter dem Markennamen VARIS® hergestellt und vertrieben. Die Größe der Umrichteranordnungen ist dabei maßgeblich von der Anzahl der Leistungshalbleiterschalter und der benötigten elektrischen Kapazität der Kondensatoren abhängig. Die elektrische Kapazität wird bevorzugt durch Leistungskondensatoren in der sogenannten zylindrischen Rundbecherform oder alternativ in Quaderform bereitgestellt. Aufgrund ihrer Größe und ihres Gewichts sind diese Komponenten häufig in einem Gehäuse aufgenommen, in welchem weitere zur Steuerung der Leistungshalbleiterschalter benötigte elektronische Komponenten, die sogenannten Leistungshalbleiterschalter-Treiber, aufgenommen sind. Dabei werden die Leistungshalbleiterschalter, die jeweils zugeordneten Leistungshalbleiterschalter-Treiber und die jeweils zugehörigen elektrischen Anschlüsse aus Gründen der Skalierbarkeit symmetrisch nebeneinander angeordnet.

Die EP 2 587 908 A2 beschreibt eine Umrichteranordnung, die einen ersten Umrichter umfasst, welcher eine Platine aufweist, auf der zwei Kondensatoren angeordnet sind, die sich mit ihren Köpfen durch Öffnungen hindurch in das Gehäuse eines zweiten Umrichters hinein erstrecken, welches auf dem Gehäuse des ersten Umrichters angeordnet ist. Das Dokument gibt keinen Hinweis darauf, auf der Platine des zweiten Umrichters Kondensatoren vorzusehen, welche sich in entsprechende Öffnungen in der Platine des ersten Umrichters hinein erstrecken.

Bei der zuvor genannten Umrichteranordnung ergibt sich das Problem, dass der benötigte Bauraum nahezu linear von der Anzahl der Leistungshalbleiterschalter einer Umrichteranordnung abhängt. Anders ausgedrückt führt eine Verdoppelung der Leistungshalbleiterschalter zu einer nahezu doppelt so großen Umrichteranordnung.

Demgemäß ist es eine Aufgabe der vorliegenden Erfindung, eine Umrichteranordnung zu schaffen, welche einen verringerten Bauraum aufweist.

Diese Aufgabe wird erfindungsgemäß durch die Merkmale von Anspruch 1 gelöst.

Weitere Merkmale der Erfindung sind in den Unteransprüchen beschrieben.

Gemäß der Erfindung umfasst eine erfindungsgemäße Umrichteranordnung einen ersten Umrichter mit einer ersten, in einer ersten Ebene angeordneten Platine, die wenigstens einen ersten elektrischen Leistungshalbleiterschalter sowie wenigstens zwei erste Leistungskondensatoren trägt. Weiterhin umfasst die Umrichteranordnung einen im Wesentlichen baugleich zum ersten Umrichter ausgebildeten zweiten Umrichter, der eine zweite Platine enthält, die wenigstens einen zweiten Leistungshalbleiterschalter und wenigstens zwei zweite Leistungskondensatoren trägt. Die Erfindung zeichnet sich dadurch aus, dass die zweite Platine den Leistungskondensatoren der ersten Platine in der Weise gegenüberliegend in einer parallel zur ersten Ebene verlaufenden zweiten Ebene angeordnet ist, dass sich die Leistungskondensatoren jeweils durch in der ersten und zweiten Platine geformte Öffnungen der jeweils gegenüberliegenden Platine hindurch, bzw. in diese hinein erstrecken.

Die Erfindung besitzt den Vorteil, dass die Bauhöhe zwischen den Platinen auf weniger als die Bauhöhe der Kondensatoren verringert werden kann, wodurch die erfindungsgemäße Umrichteranordnung wesentlich kompakter ist, als zwei getrennte Umrichter, die jeweils eine eigene einzelne Platine aufweisen, auf der die Leistungshalbleiter und Kondensatoren aufgebracht sind. Aufgrund dieser besonders kompakten erfindungsgemäßen Anordnung führt eine Verdopplung von drei Leistungshalbleiterschaltern auf sechs Leistungshalbleiterschalter in einer erfindungsgemäßen Umrichteranordnung nur zu einem geringfügig vergrößerten Bauraum, da die Höhe der Umrichteranordnung maßgeblich durch die Höhe der Leistungskondensatoren bestimmt wird. Ein weiterer Vorteil der Erfindung besteht darin, dass beim Ausfall eines einzelnen Kondensators diesen nach Lösen seiner Lötverbindungen durch die zugehörige Öffnung hindurch aus dem Gesamtpaket entnommen und ausgetauscht werden kann, ohne die Anordnung insgesamt zu zerlegen.

Bei der bevorzugten Ausführungsform der Erfindung ist zwischen den elektrischen Leistungshalbleiterschaltern der ersten und zweiten Platine ein gemeinsamer Kühlkörper angeordnet, der mit den Leistungshalbleiterschaltern der ersten und zweiten Platine wärmeleitend gekoppelt ist.

Diese Ausführungsform der Erfindung besitzt den Vorteil, dass lediglich ein gemeinsamer Kühlkörper für die Leistungshalbleiterschalter der ersten und zweiten Platine benötigt wird.

Bei der bevorzugten Ausführungsform der erfindungsgemäßen Umrichteranordnung besitzen die Leistungskondensatoren eine vorzugsweise zylindrische oder quaderförmige Form.

Diese Ausführungsform der erfindungsgemäßen Umrichteranordnung besitzt den Vorteil, dass die Leistungskondensatoren besonders dicht angeordnet werden können und die Öffnungen in der jeweiligen Platine besonders einfach zu fertigen sind.

Nach einem weiteren der Erfindung zugrunde liegenden Gedanken bilden der erste und zweite Umrichter eine Einheit. Der sich ergebene Raum zwischen der ersten und zweiten Platine ist dabei vorzugsweise zumindest teilweise umfänglich geschlossen, beispielsweise durch umfänglich angeordnete Blechwände oder Kunststoffwände. Hierdurch ergibt sich eine besonders stabile und kompakte Anordnung, die zugleich auch die gezielte Durchführung von Kühlluft ermöglicht.

Bei einer weiteren Ausführungsform trägt jede der Platinen mehr als zwei, vorzugsweise vier oder mehr Leistungskondensatoren. Die Leistungskondensatoren auf der jeweiligen ersten oder zweiten Platine sind hierbei vorzugsweise in parallel verlaufenden Reihen in einem Raster in der Weise angeordnet, dass zwischen zwei in einer Reihe benachbarten Leistungskondensatoren ein Freiraum vorgesehen ist, der vorzugsweise die Breite eines Leistungskondensators, besonders bevorzugt jedoch nur etwas mehr als die halbe Breite eines Leistungskondensators besitzt. Hierdurch ergibt sich der Vorteil, dass zwischen den Kondensatorreihen gezielt Kühlluft hindurchgeblasen werden kann, die die Gehäuse der Kondensatoren zur Abfuhr von während des Betriebs entstehender Wärme wirksam umströmt.

Nach einem weiteren Gedanken der Erfindung sind die Leistungskondensatoren zweier benachbarter Reihen bei der vorherigen- Ausführungsform in vorteilhafter Weise wechselweise versetzt zueinander angeordnet, derart, dass die Leistungskondensatoren der einen Reihe in Höhe der Freiräume der benachbarten anderen Reihe angeordnet sind. Dadurch ergibt sich der Vorteil, dass die Leistungskondensatoren in einer flächenmäßig besonders dichten Packung zueinander angeordnet werden können, wobei die Reihen bei Bedarf mitunter so dicht beabstandet zueinander angeordnet werden können, dass der Abstand der Zentren der Leistungskondensatoren zweier benachbarter Reihen sogar kleiner als der Durchmesser eines Leistungskondensators gewählt werden kann.

Bei einer weiteren Ausführungsform der Erfindung ist der lichte Abstand zwischen der ersten und zweiten Platine kleiner als die Höhe eines Leistungskondensators. Dies ergibt den Vorteil, dass die Umrichteranordnung besonders flach ausgeführt werden kann.

Gemäß einer weiteren Ausführungsform der Erfindung weisen die Platine und/oder die Leistungshalbleiterschalter elektrische Anschlüsse auf, welche auf einer Seite der Platine herausgeführt sind und von der Seite aus betrachtet in einer parallel zur ersten und zweiten Ebene verlaufenden dritten und vierten Ebene angeordnet sind. Dies ist besonders vorteilhaft, da der elektrische Anschluss einer solchen Ausführungsform der erfindungsgemäßen Umrichteranordnung zentral von einer Seite der Anordnung aus vorgenommen werden kann.

Nach einem weiteren Gedanken der Erfindung erfolgt der elektrische Anschluss der jeweiligen Platine und/oder eines Leistungshalbleiterschalters mittels einer Anschlusslasche, die vorzugsweise aus Kupfer besteht und die in eine weibliche Aufnahme, z.B. eine Buchse einer elektrischen Steckverbindung einsteckbar und/oder einschraubbar ist. Dies ermöglicht es, dass die Umrichteranordnung als eine Art steckbares Modul ausgeführt werden kann, welches beispielsweise mittels geeigneter mechanischer Führungen in eine entsprechende mechanische Aufnahme in einem Schaltschrank einschiebbar ist und anschließend mit Hilfe der Anschlüsse insbesondere durch Verschrauben elektrisch angeschlossen werden kann. Hierdurch ergibt sich der Vorteil, dass auch bei sehr hohen Strömen stets ein zuverlässiger elektrischer Kontakt erhalten wird, und dass zudem eine stabile formschlüssige mechanische Verbindung zwischen dem Schaltschrank und der erfindungsgemäßen Umricheranordnung erzeugt werden kann.

Gemäß einer weiteren Ausführungsform der Erfindung umfasst der Kühlkörper einen Flüssigkeitskühler, welcher zumindest einen Flüssigkeitseingang und Flüssigkeitsausgang aufweist, die in vorteilhafter Weise in einer weiteren parallel zur ersten und zweiten Ebene verlaufenden fünften Ebene angeordnet sind. Der Flüssigkeitseingang und Flüssigkeitsausgang sind vorzugsweise auf der gleichen Seite wie die elektrischen Anschlüsse aus dem Bereich der ersten und zweiten Platinen herausgeführt und vorzugsweise jeweils in eine Schnellkupplung einsteckbar.

Nach einem weiteren der Erfindung zugrunde liegenden Gedanken ist ein elektrischer Leistungshalbleiterschalter ein Bipolartransistor mit isolierter Gate-Elektrode (IGBT). Dies hat den besonderen Vorteil, dass die erfindungsgemäße Umrichteranordnung trotz ihrer kompakten Bauweise besonders große Ströme und/oder Spannungen schalten kann. So ist die maximale Schaltspannung der Umrichteranordnung vorzugsweise größer als 100 V, bevorzugt größer als 230 V, besonders bevorzugt größer gleich 400 V; und der maximale Strom der Umrichteranordnung ist größer als 100 A, bevorzugt größer als 250 A, besonders bevorzugt größer gleich 292 A.

Die Erfindung wird nachfolgend mit Bezug auf die Zeichnungen anhand einer bevorzugten Ausführungsform beschrieben.

In den Zeichnungen zeigen:
- Fig. 1: eine perspektivische Darstellung der erfindungsgemäßen Umrichteranordnung, umfassend zwei Platinen, 22 Leistungskondensatoren je Platine, drei Leistungshalbleiterschalter je Platine, zwei Anschlusslaschen je Platine und jeweils eine Anschlusslasche an einem Leistungshalbleiterschalter, sowie einen gemeinsamen Kühlkörper mit einem Flüssigkeitseingang und einem Flüssigkeitsausgang,
- Fig. 2: eine perspektivische Darstellung eines erfindungsgemäßen Umrichters mit einem Kühlkörper,
- Fig. 3: eine Ansicht der Unterseite einer erfindungsgemäßen Umrichteranordnung,
- Fig. 4: eine Frontansicht der Anschlussseite einer erfindungsgemäßen Umrichteranordnung, und
- Fig. 5: eine Seitenansicht einer erfindungsgemäßen Umrichteranordnung.

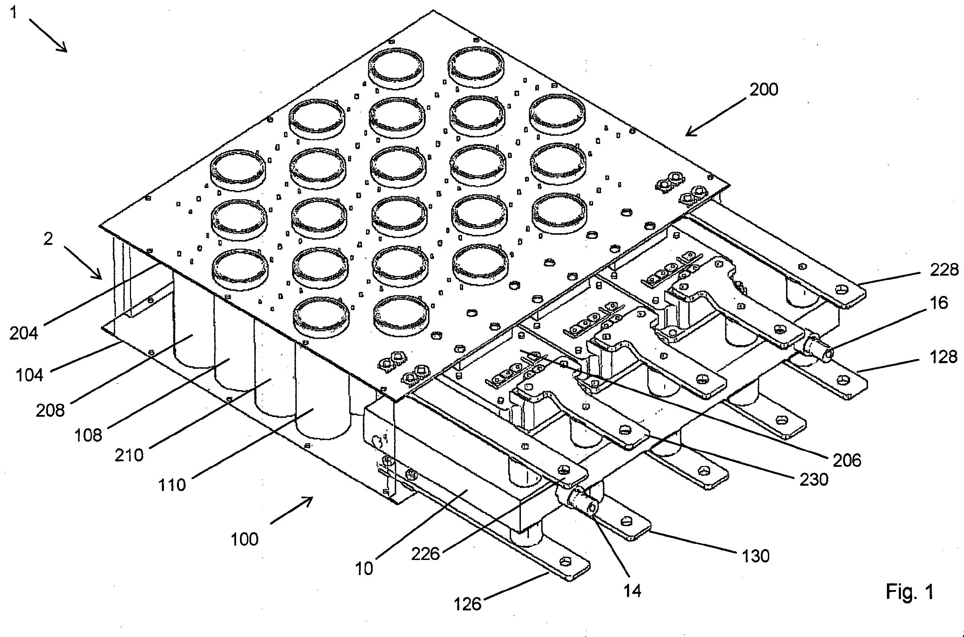

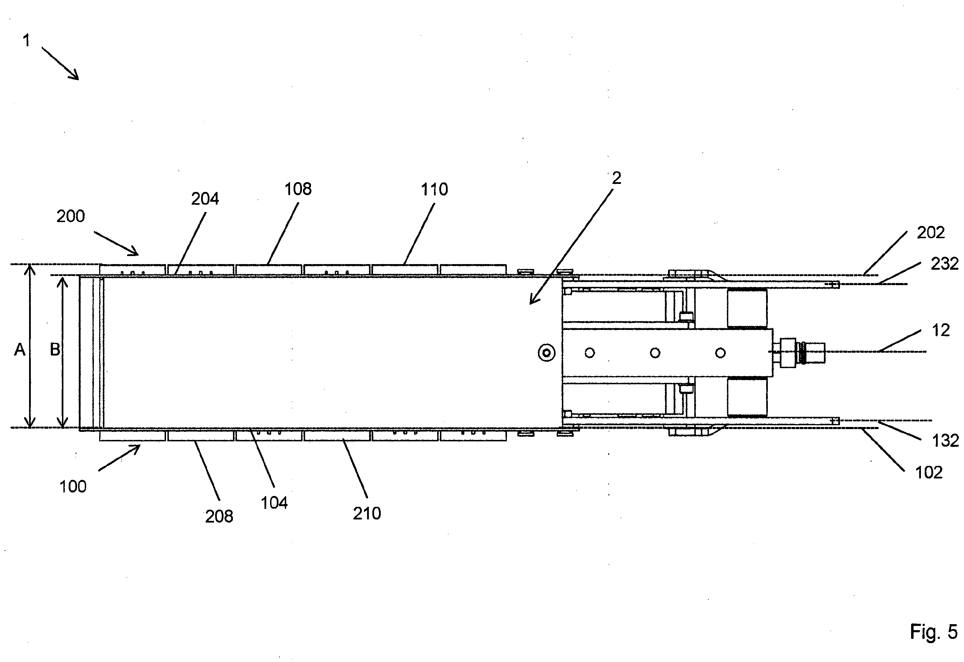

Wie in Fig. 1 gezeigt ist, umfasst eine erfindungsgemäße Umrichteranordnung 1 einen ersten Umrichter 100 mit einer ersten, in einer ersten Ebene 102 (Fig. 5) angeordneten Platine 104, die wenigstens einen ersten elektrischen Leistungshalbleiterschalter 106 sowie wenigstens zwei erste Leistungskondensatoren 108, 110 trägt. Weiterhin umfasst die Umrichteranordnung 1 einen im Wesentlichen baugleich zum ersten Umrichter 100 ausgestalteten zweiten Umrichter 200, der eine zweite Platine 204 besitzt, die wenigstens einen zweiten Leistungshalbleiterschalter 206 sowie wenigstens zwei zweite Leistungskondensatoren 208, 210 trägt. In der ersten und zweiten Platine 104, 204 sind Öffnungen 112, 212 geformt, die einen Durchmesser aufweisen, der vorzugsweise geringfügig größer als der Durchmesser der Kopfteile der Leistungskondensatoren 108, 110 ist. Gemäß der Erfindung ist die zweite Platine 204 den Leistungskondensatoren 108, 110 der ersten Platine 100 gegenüberliegend in einer parallel zur ersten Ebene 102 verlaufenden zweiten Ebene 202 angeordnet. Die räumliche Anordnung ist dabei derart, dass sich die Köpfe oder Kopfteile der Leistungskondensatoren 108, 110 der einen Platine 104 jeweils durch die Öffnungen in der anderen Platine 204 hindurcherstrecken.

Die Platinen 204, 104 werden vorzugsweise mittels elektrischer Anschlusslaschen 226, 228, 116, 118, welche gemeinsam an einer Seite der Platine 204, 104 herausgeführt sind, an einen extern elektrischen Kontakt angeschlossen. Wie den Figuren weiterhin zu entnehmen ist, sind die Leistungshalbleiterschalter 206, 106 auf der gleichen Seite wie die Anschlusslaschen 226, 228, 116, 118 der Platine nebeneinander angeordnet und mit dieser vorzugsweise mit Hilfe von nicht näher bezeichneten Schraubverbindungen, Lötverbindungen oder Steckverbindungen elektrisch verbunden, wobei der externe elektrische Anschluss der Leistungshalbleiterschalter 206, 106 bevorzugt mittels der Anschlusslaschen erfolgt. Dabei sind die elektrischen Anschlusslaschen 126, 128, 226, 228; 130, 230 der jeweiligen Platine 104, 204 und/oder eines Leistungshalbleiterschalters 106, 206 vorzugsweise aus Kupfer gefertigt und in einen weiblichen Teil einer elektrischen Steckverbindung einsteckbar und/oder mit diesem verschraubbar.

Weiterhin ist zwischen den elektrischen Leistungshalbleiterschaltern 106, 206 der ersten und zweiten Platine 104, 204 ein gemeinsamer Kühlkörper 10 angeordnet, der mit den Leistungshalbleiterschaltern 106, 206 wärmeleitend gekoppelt ist. Der Kühlkörper 10 ist vorzugsweise ein Flüssigkeitskühler, dessen Flüssigkeitseingang 14 und Flüssigkeitsausgang 16 bevorzugt an derselben Seite wie die elektrischen Anschlusslaschen 126, 128, 226, 228 aus der Umrichteranordnung 1 herausgeführt sind. Die Anschlusslaschen 126,128, 226, 228 sind im Bereich des Kühlkörpers 10 bevorzugt mit Hilfe nicht näher bezeichneter isolierter Abstandshalter befestigt.

Die Leistungskondensatoren 108, 110, 114, 116, 208, 210, 214, 216 sind bevorzugt zylindrisch nach Art eines Rundbechers ausgeführt; können aber auch quaderartig sein. Die Leistungskondensatoren werden bevorzugt in der Weise auf einem Raster angeordnet, dass die Kopfteile der Kondensatoren der einen Platine deckungsgleich in die Öffnungen der vorzugsweise nahezu identisch ausgeführten zweiten Platine eingesteckt werden können und die Leistungskondensatoren 108, 110, 114, 116, 208, 210, 214, 216 der beiden Platinen 104, 204 ineinander greifen. Die zusammengesteckten Platinen 104, 204 sind zumindest teilweise umfänglich im Bereich des Zwischenraums 2 mit Hilfe von nicht näher bezeichneten Platten verschlossen und bilden eine mechanisch stabile Einheit, in der sich die Umfangsflächen der Leistungskondensatoren zur Erhöhung der mechanischen Stabilität gegenüber Schubkräften auf die Platinen zumindest teilweise an den Innenrändern der jeweiligen Öffnungen abstützen.

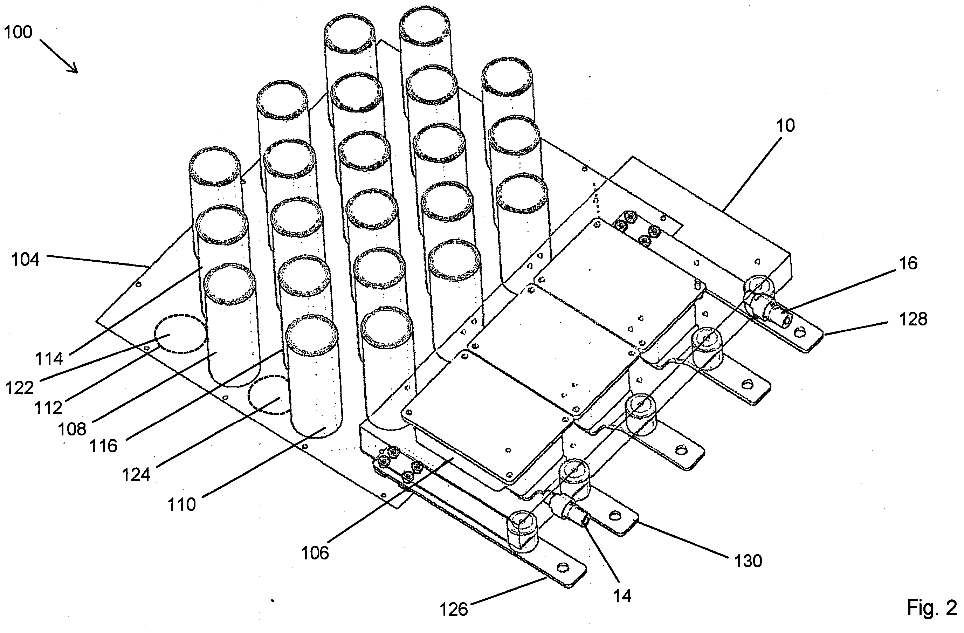

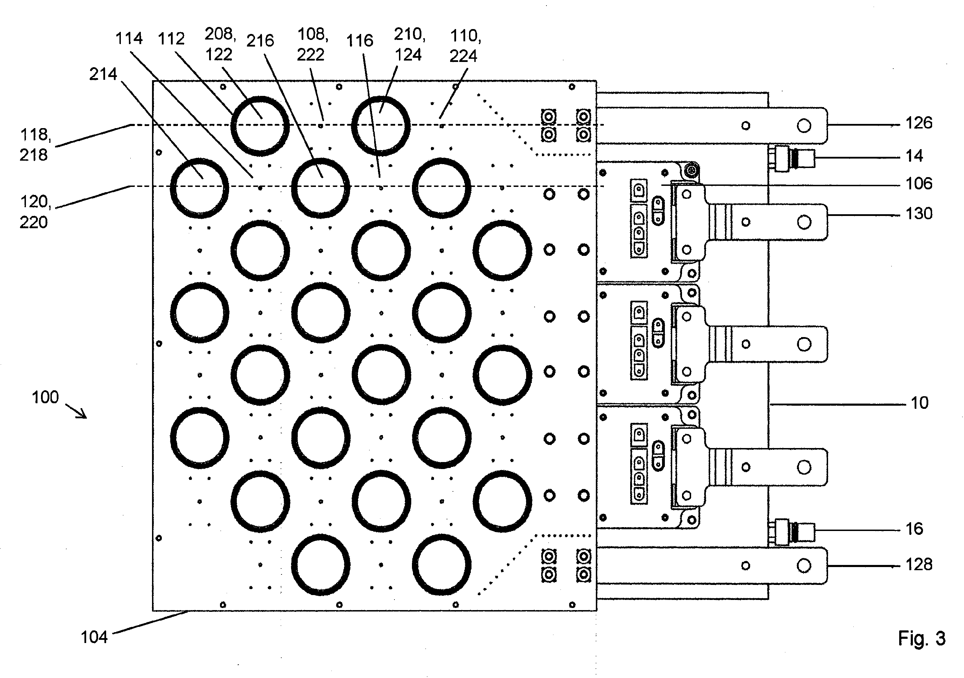

Wie weiterhin den Figuren 2 und 3 zu entnehmen ist, trägt jede der Platinen 104, 204 mehr als zwei, vorzugsweise mehr als vier, besonders bevorzugt bis zu 22 Leistungskondensatoren 108, 110, 114, 116. Die Leistungskondensatoren 108, 110, 114, 116 auf der jeweils ersten oder zweiten Platine 104, 204 sind vorzugsweise in parallel verlaufenden Reihen 118, 120 in einem Raster in der Weise angeordnet, dass zwischen zwei in einer Reihe 118, 120 benachbarten Leistungskondensatoren 108, 110, 114, 116 ein Freiraum 122,124 vorgesehen ist, der mindestens die halbe Breite, bzw. den halben Durchmesser eines Leistungskondensators 108, 110, 114, 116, vorzugsweise jedoch die Breite, bzw. den vollen Durchmesser eines Leistungskondensators besitzt. In den Freiräumen 122, 124 sind vorzugsweise Öffnungen 112 angeordnet, in die hinein die Köpfe der Leistungskondensatoren 208, 210, 214, 216 der jeweils anderen Platine 204, 104 einsteckbar sind.

Die Leistungskondensatoren 108, 110, 114, 116, 208, 210, 214, 216 zweier benachbarter Reihen 118, 120, 218, 220 sind dabei wechselweise so versetzt zueinander angeordnet, dass die Leistungskondensatoren 108, 110, 208, 210 der einen Reihe 118, 218; 120, 220 in Höhe der Freiräume 124, 224; 122, 222 der benachbarten anderen Reihe 120, 220; 118, 218 liegen.

Weiterhin ist in Fig. 3 gezeigt, dass die Anschlusslaschen 126,128,130,226,228,230 vorzugsweise außerhalb der Umrichteranordnung 1 entlang einer nicht näher gezeigten gemeinsamen Ebene enden.

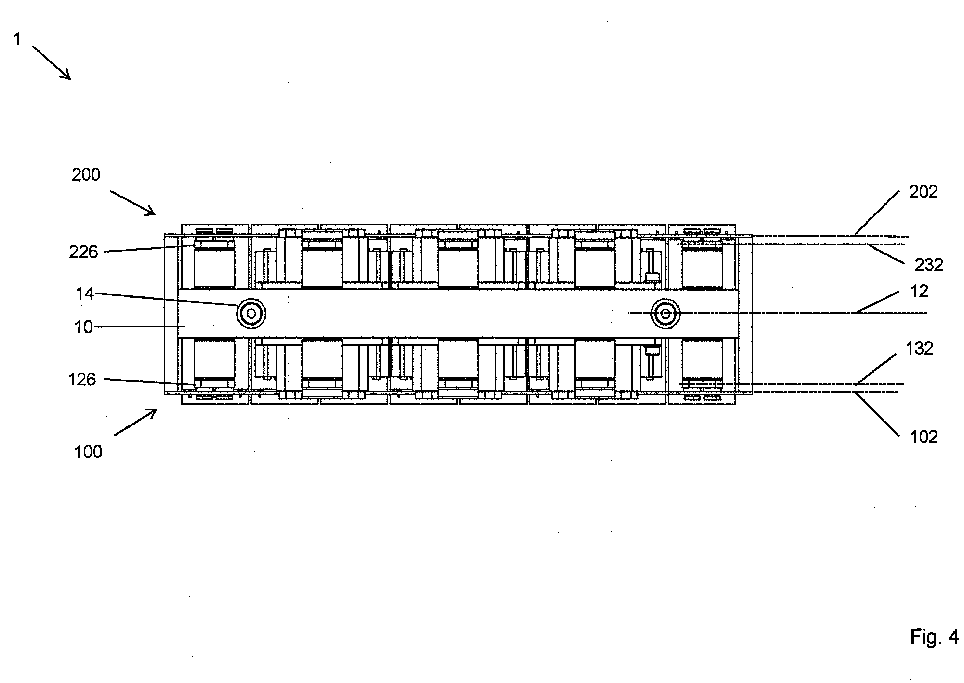

Die Figuren 4 und 5 zeigen, dass der lichte Abstand B zwischen der ersten und zweiten Platine 104, 204 kleiner als die Höhe A eines Leistungskondensators 108, 110, 114, 116, 208, 210, 214, 216 ist. Ferner ist gezeigt, dass die elektrischen Anschlüsse 126, 128, 226, 228; 130, 230 auf einer Seite der Platine 104, 206 herausgeführt sind und von der Seite aus betrachtet in einer parallel zur ersten und zweiten Ebene 102, 202 verlaufenden dritten und vierten Ebene 132, 232 liegen.

Wie den Figuren 4 und 5 weiterhin entnommen werden kann, umfasst der Kühlkörper 10 einen Flüssigkeitskühler, welcher zumindest einen Flüssigkeitseingang 14 und einen Flüssigkeitsausgang 16 aufweist, die in einer weiteren parallel zur ersten und zweiten Ebene 102, 202 verlaufenden fünften Ebene 12 angeordnet sind. Der Flüssigkeitseingang 14 und Flüssigkeitsausgang 16 sind vorzugsweise auf der gleichen Seite wie die elektrischen Anschlüsse 126, 128, 226, 228; 130, 230 aus dem Bereich der ersten und zweiten Platinen 104, 204 herausgeführt und jeweils vorzugsweise derart ausgestaltet, dass sie in eine Schnellkupplung einsteckbar sind.

Die elektrischen Leistungshalbleiterschalter 106, 206 sind vorzugsweise Bipolartransistoren mit isolierter Gate-Elektrode (IGBTs). Wie in Fig. 4 gezeigt ist, werden die IGBTs 106, 206 zweier ineinander gesteckter Platinen 104, 204 vorzugsweise gegenüberliegend am Kühlkörper 10 aufgenommen und sind wärmeleitend mit diesem verbunden.

### Liste der Bezugszeichen

- 1: Erfindungsgemäße Umrichteranordnung
- 2: Zwischenraum
- 10: Kühlkörper
- 12: fünfte Ebene
- 14: Flüssigkeitseingang
- 16: Flüssigkeitsausgang
- 100: erster Umrichter
- 102: erste Ebene
- 104: erste Platine
- 106: erster Leistungshalbleiterschalter
- 108: Leistungskondensator
- 110: Leistungskondensator
- 112: Öffnung
- 114: Leistungskondensator
- 116: Leistungskondensator
- 118: erste Reihe
- 120: zweite Reihe
- 122: Freiraum
- 124: Freiraum
- 126: elektrischer Anschluss der Platine
- 128: elektrischer Anschluss der Platine
- 130: elektrischer Anschluss des Leistungshalbleiterschalters
- 132: dritte Ebene
- 200: zweiter Umrichter
- 202: zweite Ebene
- 204: zweite Platine
- 206: erster Leistungshalbleiterschalter
- 208: Leistungskondensator
- 210: Leistungskondensator
- 212: Öffnung
- 214: Leistungskondensator
- 216: Leistungskondensator
- 218: erste Reihe
- 220: zweite Reihe
- 222: Freiraum
- 224: Freiraum
- 226: elektrischer Anschluss der Platine
- 228: elektrischer Anschluss der Platine
- 230: elektrischer Anschluss des Leistungshalbleiterschalters
- 232: vierte Ebene
- A: Höhe eines Leistungskondensators
- B: lichter Abstand

## Patentansprüche

1. Umrichteranordnung (1) enthaltend einen ersten Umrichter (100) mit einer ersten, in einer ersten Ebene (102) angeordneten Platine (104), die wenigstens einen ersten elektrischen Leistungshalbleiterschalter (106) sowie wenigstens zwei erste Leistungskondensatoren (108, 110) trägt, sowie mit einem im Wesentlichen baugleich zum ersten Umrichter (100) ausgestalteten zweiten Umrichter (200), der eine zweite Platine (204) umfasst, die wenigstens einen zweiten Leistungshalbleiterschalter (206) sowie wenigstens zwei zweite Leistungskondensatoren (208, 210) trägt,
**dadurch gekennzeichnet,**
**dass** die zweite Platine (204) den Leistungskondensatoren (108, 110) der ersten Platine (104) gegenüberliegend in einer parallel zur ersten Ebene (102) verlaufenden zweiten Ebene (202) angeordnet ist, und dass in der ersten und zweiten Platine (104, 204) Öffnungen (112, 212) geformt sind, durch die die Leistungskondensatoren (108, 110, 208, 210) der jeweils gegenüberliegenden Platine (104, 204) hindurchsteckbar sind.

2. Umrichteranordnung nach Anspruch 1,
**dadurch gekennzeichnet,**
**dass** zwischen den elektrischen Leistungshalbleiterschaltern (106, 206) der ersten und zweiten Platine (104, 204) ein gemeinsamer Kühlkörper (10) angeordnet ist, der mit den Leistungshalbleiterschaltern (106, 206) der ersten und zweiten Platine (104, 204) wärmeleitend gekoppelt ist.

3. Umrichteranordnung nach einem der vorhergehenden Ansprüche,
**dadurch gekennzeichnet,**
**dass** die Leistungskondensatoren (108, 110, 208, 210) eine zylindrische Bauform aufweisen.

4. Umrichteranordnung nach einem der vorhergehenden Ansprüche,
**dadurch gekennzeichnet,**
**dass** der erste und zweite Umrichter (100, 200) eine Einheit bilden, und der sich ergebene Zwischenraum (2) der ersten und zweiten Platine (104, 204) zumindest teilweise umfänglich geschlossen ist.

5. Umrichteranordnung nach einem der vorhergehenden Ansprüche,
**dadurch gekennzeichnet,**
**dass** jede der Platinen (104, 204) mehr als zwei, vorzugsweise vier oder mehr Leistungskondensatoren (108, 110, 114, 116, 208, 210, 214, 216) trägt, und dass die Leistungskondensatoren (108, 110, 114, 116, 208, 210, 214, 216) auf der jeweiligen ersten oder zweiten Platine (104, 204) vorzugsweise in parallel verlaufenden Reihen (118, 120, 218, 220) in einem Raster in der Weise angeordnet sind, dass zwischen zwei benachbarten Leistungskondensatoren (108, 110, 114, 116) einer Reihe (118, 120, 218, 220) ein Freiraum (122, 124, 222, 224) vorgesehen ist, der vorzugsweise wenigstens die Breite eines Leistungskondensators (108, 110, 114, 116, 208, 210, 214, 216) besitzt.

6. Umrichteranordnung nach Anspruch 5,
**dadurch gekennzeichnet,**
**dass** die Leistungskondensatoren (108, 110, 114, 116, 208, 210, 214, 216) zweier benachbarter Reihen (118, 120, 218, 220) wechselweise versetzt zueinander angeordnet sind, derart, dass die Leistungskondensatoren (108, 110, 208, 210) der ersten Reihe (118, 218; 120, 220) in Höhe der Freiräume (124, 224; 122, 222) der benachbarten zweiten Reihe (120, 220; 118, 218) angeordnet sind.

7. Umrichteranordnung nach einem der vorhergehenden Ansprüche,
**dadurch gekennzeichnet,**
**dass** der lichte Abstand (B) zwischen der ersten und zweiten Platine (104, 204) kleiner als die Höhe (A) eines Leistungskondensators (108, 110, 114, 116, 208, 210, 214, 216) ist.

8. Umrichteranordnung nach einem der vorhergehenden Ansprüche,
**dadurch gekennzeichnet,**
**dass** die Platine (104, 204) und/oder die Leistungshalbleiterschalter (106, 206) elektrische Anschlüsse (126, 128, 226, 228; 130, 230) aufweisen, welche auf einer Seite der Platine (104, 206) herausgeführt sind und von der Seite betrachtet in einer parallel zur ersten und zweiten Ebene (102, 202) verlaufenden dritten und vierten Ebene (132, 232) angeordnet sind.

9. Umrichteranordnung nach Anspruch 8,
**dadurch gekennzeichnet,**
**dass** der elektrische Anschluss (126, 128, 226, 228; 130, 230) der jeweiligen Platine (104, 204) und/oder eines Leistungshalbleiterschalters (106, 206) mittels einer Anschlusslasche erfolgt, die vorzugsweise aus Kupfer besteht und in einen weiblichen Teil einer elektrischen Steckverbindung einsteckbar und/oder schraubbar ist.

10. Umrichteranordnung nach Anspruch 8 oder 9,
**dadurch gekennzeichnet,**
**dass** der Kühlkörper (10) ein Flüssigkeitskühler umfasst, welcher zumindest einen in einer weiteren parallel zur ersten und zweiten Ebene (102, 202) verlaufenden fünften Ebene (12) angeordneten Flüssigkeitseingang (14) und Flüssigkeitsausgang (16) aufweist, wobei der Flüssigkeitseingang (14) und Flüssigkeitsausgang (16) vorzugsweise auf der gleichen Seite wie die elektrischen Anschlüsse (126, 128, 226, 228; 130, 230) aus dem Bereich der ersten und zweiten Platinen (104, 204) herausgeführt und jeweils vorzugsweise in eine Schnellkupplung einsteckbar sind.

11. Umrichteranordnung nach einem der vorhergehenden Ansprüche,
**dadurch gekennzeichnet,**
**dass** wenigstens einer der elektrischen Leistungshalbleiterschalter (106, 206) ein Bipolartransistor mit isolierter Gate-Elektrode (IGBT) ist.

## Claims

1. A converter arrangement (1) containing a first converter (100) having a first circuit board (104), arranged in a first plane (102), which bears at least one first electrical power semiconductor switch (106) and also at least two first power capacitors (108, 110), and also having a second converter (200) of substantially identical construction to the first converter (100), which second converter comprises a second printed circuit board (204) which bears at least one second power semiconductor switch (206) and also at least two second power capacitors (208, 210),
**characterised in that**
the second circuit board (204) is arranged, lying opposite the power capacitors (108, 110) of the first circuit board (104), in a second plane (202) running parallel to the first plane (102), and **in that** openings (112, 212) are formed in the first and second circuit board (104, 204) through which the power capacitors (108, 110, 208, 210) of the circuit board (104, 204) which lies opposite in each case can be inserted.

2. A converter arrangement according to Claim 1,
**characterised in that**
a common heat sink (10) is arranged between the electrical power semiconductor switches (106, 206) of the first and second circuit boards (104, 204), which heat sink is coupled in a thermally conductive manner with the power semiconductor switches (106, 206) of the first and second circuit boards (104, 204).

3. A converter arrangement according to one of the preceding claims,
**characterised in that**
the power capacitors (108, 110, 208, 210) are of cylindrical design.

4. A converter arrangement according to one of the preceding claims,
**characterised in that**
the first and second converters (100, 200) form a unit, and the resultant gap (2) between the first and second circuit boards (104, 204) is at least partially peripherally closed.

5. A converter arrangement according to one of the preceding claims,
**characterised in that**
each of the circuit boards (104, 204) bears more than two, preferably four or more, power capacitors (108, 110, 114, 116, 208, 210, 214, 216), and **in that** the power capacitors (108, 110, 114, 116, 208, 210, 214, 216) are arranged on the respective first or second circuit board (104, 204) preferably in parallel rows (118, 120, 218, 220) in a grid pattern in such a manner that a clearance (122, 124, 222, 224) is provided between two adjacent power capacitors (108, 110, 114, 116) of a row (118, 120, 218, 220), which clearance is preferably at least the width of a power capacitor (108, 110, 114, 116, 208, 210, 214, 216).

6. A converter arrangement according to Claim 5,
**characterised in that**
the power capacitors (108, 110, 114, 116, 208, 210, 214, 216) of two adjacent rows (118, 120, 218, 220) are arranged alternately offset relative to each other such that the power capacitors (108, 110, 208, 210) of the first row (118, 218; 120, 220) are arranged at the level of the clearances (124, 224; 122, 222) of the adjacent second row (120, 220; 118, 218).

7. A converter arrangement according to one of the preceding claims,
**characterised in that**
the clear distance (B) between the first and second circuit board (104, 204) is less than the height (A) of a power capacitor (108, 110, 114, 116, 208, 210, 214, 216).

8. A converter arrangement according to one of the preceding claims,
**characterised in that**
the printed circuit board (104, 204) and/or the power semiconductor switches (106, 206) have electrical connections (126, 128, 226, 228; 130, 230) which are brought out on one side of the circuit board (104, 206) and, viewed from the side, are arranged in a third and fourth plane (132, 232) running parallel to the first and second plane (102, 202).

9. A converter arrangement according to Claim 8,
**characterised in that**
the electrical connection (126, 128, 226, 228; 130, 230) of the respective circuit board (104, 204) and/or of a power semiconductor switch (106, 206) is brought about by means of a connecting lug, which preferably consists of copper and can be inserted and/or screwed into a female part of an electrical plug-in connection.

10. A converter arrangement according to Claim 8 or 9,
**characterised in that**
the heat sink (10) comprises a fluid cooler which has at least one fluid inlet (14) and fluid outlet (16) arranged in a further fifth plane (12) running parallel to the first and second plane (102, 202), the fluid inlet (14) and fluid outlet (16) being brought out of the region of the first and second circuit boards (104, 204) preferably on the same side as the electrical connections (126, 128, 226, 228; 130, 230) and in each case preferably being able to be inserted into a quick coupling.

11. A converter arrangement according to one of the preceding claims,
**characterised in that**
at least one of the electrical power semiconductor switches (106, 206) is a bipolar transistor with an insulated gate electrode (IGBT).

## Revendications

1. Ensemble de convertisseurs (1) contenant un premier convertisseur (100) avec une première platine (104) disposée dans un premier plan (102), laquelle porte au moins un premier commutateur à semi-conducteur de puissance électrique (106) ainsi qu'au moins deux premiers condensateurs de puissance (108, 110), ainsi qu'avec un deuxième convertisseur (200) agencé selon sensiblement la même structure que le premier convertisseur (100), lequel comporte une deuxième platine (204), laquelle porte au moins un deuxième commutateur à semi-conducteur de puissance (206) ainsi qu'au moins deux deuxièmes condensateurs de puissance (208, 210),
**caractérisé**
**en ce que** la deuxième platine (204) est disposée en face des condensateurs de puissance (108, 110) de la première platine (104) dans un deuxième plan (202) s'étendant parallèlement au premier plan (102), et **en ce que** des ouvertures (112, 212) sont formées dans les première et deuxième platines (104, 204), à travers lesquelles les condensateurs de puissance (108, 110, 208, 210) des platines (104, 204) se faisant respectivement face sont enfichables.

2. Ensemble de convertisseurs selon la revendication 1,
**caractérisé**
**en ce qu'**un corps de refroidissement commun (10) est disposé entre les commutateurs à semi-conducteur de puissance électriques (106, 206) des première et deuxième platines (104, 204), lequel est couplé de manière thermoconductrice aux commutateurs à semi-conducteur de puissance (106, 206) des première et deuxième platines (104, 204).

3. Ensemble de convertisseurs selon l'une des revendications précédentes,
**caractérisé**
**en ce que** les condensateurs de puissance (108, 110, 208, 210) comprennent une forme de construction cylindrique.

4. Ensemble de convertisseurs selon l'une des revendications précédentes,
**caractérisé**
**en ce que** les premier et deuxième convertisseurs (100, 200) forment une unité, et l'intervalle (2) s'ensuivant entre les première et deuxième platines (104, 204) est fermé au moins en partie sur la périphérie.

5. Ensemble de convertisseurs selon l'une des revendications précédentes,
**caractérisé**
**en ce que** chacune des platines (104, 204) porte plus de deux, de préférence quatre condensateurs de puissance (108, 110, 114, 116, 208, 210, 214, 216) ou plus, et **en ce que** les condensateurs de puissance (108, 110, 114, 116, 208, 210, 214, 216) sont disposés sur la première ou deuxième platine (104, 204) respective, de préférence en rangées s'étendant parallèlement (118, 120, 218, 220) dans un quadrillage de façon à ce qu'entre deux condensateurs de puissance adjacents (108, 110, 114, 116) d'une rangée (118, 120, 218, 220) soit prévu un espace libre (122, 124, 222, 224) qui possède de préférence au moins la largeur d'un condensateur de puissance (108, 110, 114, 116, 208, 210, 214, 216).

6. Ensemble de convertisseurs selon la revendication 5,
**caractérisé**
**en ce que** les condensateurs de puissance (108, 110, 114, 116, 208, 210, 214, 216) de deux rangées adjacentes (118, 120, 218, 220) sont disposés en alternance de manière décalée les uns par rapport aux autres de telle sorte que les condensateurs de puissance (108, 110, 208, 210) de la première rangée (118, 218 ; 120, 220) soient disposés au niveau des espaces libres (124, 224 ; 122, 222) de la deuxième rangée adjacente (120, 220 ; 118, 218).

7. Ensemble de convertisseurs selon l'une des revendications précédentes,
**caractérisé**
**en ce que** l'écart intérieur (B) entre les première et deuxième platines (104, 204) est inférieur à la hauteur (A) d'un condensateur de puissance (108, 110, 114, 116, 208, 210, 214, 216).

8. Ensemble de convertisseurs selon l'une des revendications précédentes,
**caractérisé**
**en ce que** les platines (104, 204) et/ou les commutateurs à semi-conducteur de puissance (106, 206) comprennent des connexions électriques (126, 128, 226, 228 ; 130, 230), lesquelles débouchent sur un côté des platines (104, 206) et sont disposées dans des troisième et quatrième plans (132, 232) s'étendant parallèlement aux premier et deuxième plans (102, 202), vues depuis le côté.

9. Ensemble de convertisseurs selon la revendication 8,
**caractérisé**
**en ce que** la connexion électrique (126, 128, 226, 228 ; 130, 230) de la platine (104, 204) respective et/ou d'un commutateur à semi-conducteur de puissance (106, 206) s'effectue au moyen d'une patte de connexion qui est constituée de préférence de cuivre et est enfichable et/ou peut être vissée dans une partie femelle d'un connecteur électrique à fiches.

10. Ensemble de convertisseurs selon la revendication 8 ou la revendication 9,
**caractérisé**
**en ce que** le corps de refroidissement (10) comporte un refroidisseur de liquide, lequel comprend au moins une entrée de liquide (14) et une sortie de liquide (16) disposées dans un cinquième plan (12) supplémentaire s'étendant parallèlement aux premier et deuxième plans (102, 202), dans lequel l'entrée de liquide (14) et la sortie de liquide (16) débouchent de préférence sur le même côté que les connexions électriques (126, 128, 226, 228 ; 130, 230) de la zone des première et deuxième platines (104, 204) et sont respectivement enfichables de préférence dans un raccord rapide.

11. Ensemble de convertisseurs selon l'une des revendications précédentes,
**caractérisé**
**en ce qu'**au moins l'un des commutateurs à semi-conducteur de puissance électriques (106, 206) est un transistor bipolaire avec une électrode à grille isolée (IGBT).
